# FASCICULE DE BREVET EUROPEEN

(11) **EP 2 469 711 B1**
(45) Date de publication et mention de la délivrance du brevet: **21.10.2020**
(21) Numéro de dépôt: 11194287.6
(22) Date de dépôt: 19.12.2011
(51) Int. Cl.: H03K 17/12, H02H 3/08

(54) **Dispositif de commutation électrique, notamment pour la commutation de forts courants électriques**
Elektrische Schaltvorrichtung, insbesondere für die Umschaltung von starken elektrischen Strömen
Electrical switching device, in particular for switching strong electrical currents

(30) Priorité: 23.12.2010 FR 1061199
(43) Date de publication de la demande: 27.06.2012
(73) Titulaire: ALSTOM Transport Technologies, 93400 Saint-Ouen (FR)
(72) Inventeur: Dagdag, Selim, 65000 Tarbes (FR)
(74) Mandataire: Lavoix

(56) Documents cités:
- EP-A1- 0 618 679
- EP-A2- 0 517 261
- US-A1- 2004 252 430
- US-A1- 2009 096 511

## Description

La présente invention concerne un dispositif de commutation électrique, notamment pour la commutation de forts courants électriques.

On connaît déjà, dans l'état de la technique, un dispositif de commutation électrique, du type comportant une pluralité d'interrupteurs électroniques commandables, comprenant chacun une première électrode principale, une seconde électrode principale et une électrode de commande.

EP 0 517 261 décrit également un exemple de dispositif de commutation électrique.

Ces interrupteurs commandables sont choisis parmi tous composants électroniques comportant au moins une électrode de commande de commutation. Généralement, ces interrupteurs commandables sont des semi-conducteurs, tels que des transistors ou des thyristors. Par exemple, chaque interrupteur commandable peut être un transistor à effet de champs, auquel cas la première électrode principale est appelée « électrode de drain », la seconde électrode principale est appelée « électrode de source », et l'électrode de commande est appelée « électrode de grille ».

Dans un tel dispositif de commutation, les interrupteurs commandable sont habituellement tous connectés en parallèle entre leurs premières et secondes électrodes principales, et commandés à leurs électrodes de commande par un circuit de commande commun.

Lorsque le dispositif de commutation comporte un grand nombre d'interrupteurs commandables, des décalages temporels relativement importants apparaissent entre les moments où des interrupteurs éloignés les uns des autres commutent. Ces décalages entraînent des difficultés pour la commande du dispositif de commutation dans son ensemble, réduisant ainsi les performances et la fiabilité d'un tel dispositif.

Ces décalages sont notamment liés à la présence d'impédances parasites dans les moyens de connexion électrique des interrupteurs entre eux. De telles impédances parasites peuvent être toute combinaison d'inductances parasites et de capacités parasites, et sont notamment fonction de la longueur de ces moyens de connexion électrique.

Or, les moyens de connexion électrique d'un interrupteur dans le circuit sont plus ou moins longs en fonction de la position de cet interrupteur dans le circuit. Ainsi, les impédances parasites associées à un interrupteur diffèrent en fonction de cette position de cet interrupteur dans le circuit.

L'invention a notamment pour but de remédier à cet inconvénient, en fournissant un dispositif de commutation électrique à commutation rapide, dans lequel les commutations des interrupteurs sont sensiblement simultanées malgré la présence des impédances parasites.

A cet effet, l'invention a notamment pour objet un dispositif de commutation électrique selon la revendication 1.

Un tel arrangement en matrice permet de limiter les disparités entre les impédances parasites.

En effet, les interrupteurs d'une même ligne sont tous agencés de la même manière dans leur colonne respective, en étant connectés aux autres interrupteurs de la colonne à l'aide de moyens de connexion similaires. Ainsi, les interrupteurs d'une même ligne sont associés à des impédances parasites sensiblement identiques.

L'invention prévoit alors d'utiliser des branches de commandes distinctes pour commander les interrupteurs par lignes, de sorte que les interrupteurs de chaque ligne, dont les impédances parasites associées sont sensiblement identiques, commutent sensiblement simultanément.

Un autre avantage de cet arrangement en matrice consiste en ce que les lignes sont indépendantes les unes des autres, si bien que le dispositif de commutation peut continuer à fonctionner, en mode dégradé, en cas de dysfonctionnement sur une ligne.

Par ailleurs, cet arrangement en matrice permet également de limiter les inductances de boucle pouvant apparaître dans un circuit comprenant le dispositif de commutation électrique.

On rappelle que les inductances de boucle sont des inductances parasites dans le circuit de puissance passant par les première et seconde électrodes principales des interrupteurs. Ces inductances de boucle génèrent habituellement des surtensions aux bornes des interrupteurs lors de leur commutation.

Du fait de l'arrangement en matrice, les courants passant par les électrodes principales des interrupteurs circulent de manière parallèle, dans un même sens. Un tel montage a pour effet de réduire l'inductance de boucle, tout en permettant de mettre en parallèle un grand nombre d'interrupteurs commandables.

Un dispositif de commutation selon l'invention peut comporter en outre l'une ou plusieurs des caractéristiques suivantes, prises seules ou selon toutes les combinaisons techniquement possibles :
- chaque branche de commande est activée au moyen d'un dispositif d'activation commun ;
- chaque branche de commande est reliée aux électrodes de commande des interrupteurs d'au moins deux lignes adjacentes ;
- chaque colonne comporte au moins une diode comprenant une anode reliée à la première branche électrique, et une cathode reliée à la seconde branche électrique ;
- chaque interrupteur est un transistor ;
- la seconde électrode principale de chaque interrupteur est reliée à la deuxième piste au moyen d'une bille conductrice ;
- le second substrat présente une face inférieure, portant la deuxième piste, et une face supérieure opposée à la face inférieure, portant une troisième piste conductrice, reliée électriquement à la deuxième piste au moyen d'éléments de connexion traversant le second substrat ;
- le premier substrat comporte au moins une piste de commande, reliée électriquement à l'électrode de commande d'au moins un interrupteur, et le dispositif comporte une broche de commande reliée à cette piste de commande, s'étendant perpendiculairement au premier substrat depuis cette piste de commande jusqu'à une carte de commande comprenant au moins une branche de commande d'une ligne ;
- le dispositif de commutation comporte au moins une broche de retour, reliée électriquement à la deuxième piste électrique, s'étendant perpendiculairement au second substrat jusqu'à la carte de commande ;
- au moins un élément de commande est agencé, au moins en partie, sur le premier substrat ;
- le dispositif de commutation comporte une carte de découplage, comprenant au moins deux circuits de découplage, chaque circuit de découplage étant agencé en parallèle d'une colonne, afin de limiter les interférences entre ces colonnes.

L'invention concerne également un bras d'onduleur comportant :
- un premier et un second dispositif de commutation identiques tel que défini précédemment,
- une première borne, dite borne positive, connectée à la première branche de chaque colonne du premier dispositif de commutation,
- au moins un pont conducteur, reliant électriquement la seconde branche d'une colonne du premier dispositif de commutation avec la première branche d'une colonne du second dispositif de commutation,
- une deuxième borne, dite borne de phase, relié électriquement au pont conducteur, et
- une troisième borne, dite borne négative, connectée à la seconde branche de chaque colonne du second dispositif de commutation.

Un onduleur comportant un tel bras d'onduleur est par exemple destiné à équiper un véhicule ferroviaire, afin de convertir un courant continu fourni par une caténaire en un courant alternatif pour alimenter un moteur du train en électricité.

L'invention concerne par ailleurs un véhicule ferroviaire à alimentation électrique, comportant au moins un moteur électrique, caractérisé en ce qu'il comporte au moins un onduleur, comprenant trois bras d'onduleur tel que défini ci-dessus, destiné à alimenter le moteur en électricité.

L'invention concerne en outre un système de traction électrique, notamment pour une application ferroviaire, automobile, ou aéronautique, caractérisé en ce qu'il comporte un dispositif de commutation tel que défini précédemment.

L'invention concerne enfin un système de conversion ou de production d'énergie, notamment pour une application nucléaire, éolienne ou hydroélectrique, caractérisé en ce qu'il comporte un dispositif de commutation tel que défini précédemment.

L'invention sera mieux comprise à la lecture de la description qui va suivre, donnée uniquement à titre d'exemple et faite en se référant aux figures annexées, parmi lesquelles :
- la figure 1 est une vue schématique d'un dispositif de commutation électrique, formant une matrice d'interrupteurs, selon un exemple de mode de réalisation de l'invention,
- la figure 2 est une vue de dessus d'un bras d'onduleur comportant deux dispositifs de commutation comportant chacun une matrice d'interrupteurs similaire à celle de la figure 1,
- la figure 3 est un détail de la figure 2, représentant une colonne d'une matrice d'interrupteurs de cette figure 2,
- la figure 4 est un schéma électrique représentant la colonne de la figure 3,
- la figure 5 est une vue en coupe transversale du bras d'onduleur de la figure 2, et
- la figure 6 est un schéma électrique simplifié du bras d'onduleur de la figure 2.

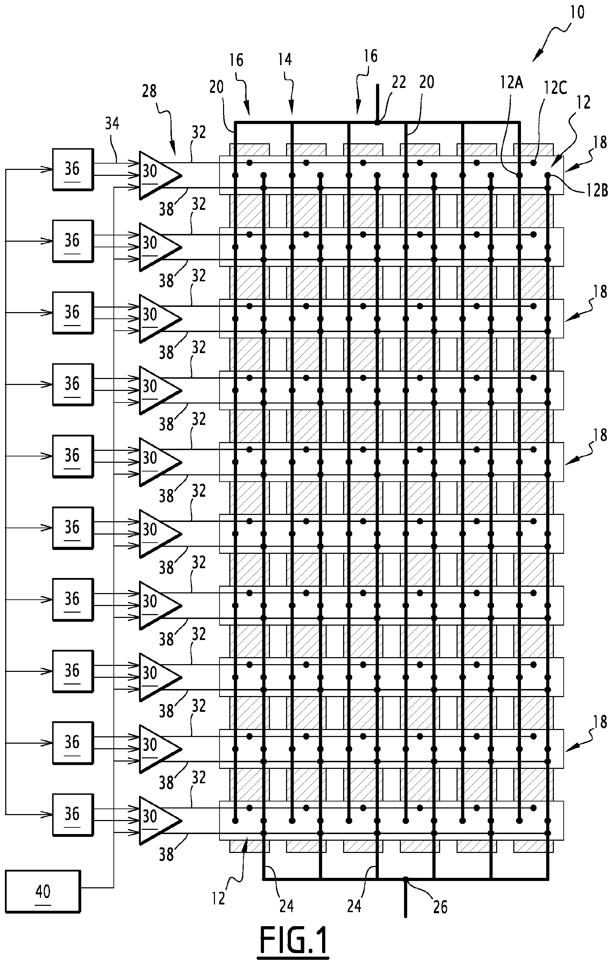

On a représenté sur la figure 1 un dispositif 10 de commutation électrique du type comportant une pluralité d'interrupteurs électroniques commandables, chaque interrupteur portant la référence 12.

Chaque interrupteur électronique commandable 12 comporte de manière classique une première électrode principale 12A, une seconde électrode principale 12B et une électrode de commande 12C.

Par exemple, chaque interrupteur électronique commandable 12 est un transistor à effet de champ de type VJFET. Dans ce cas, la première électrode principale 12A est appelée «électrode de drain», la seconde électrode principale 12B est appelée « électrode de source» et l'électrode de commande 12C est appelée «électrode de grille ».

Comme cela est représenté sur la figure 1, les interrupteurs 12 sont agencés de façon à former une matrice 14 comprenant au moins deux colonnes 16, par exemple six colonnes 16, dans lesquelles chaque colonne 16 comporte au moins deux interrupteurs 12, par exemple dix interrupteurs 12.

La matrice 14 comporte également des lignes 18, par exemple dix lignes 18, comprenant chacune l'un des interrupteurs 12 de chaque colonne 16.

Chaque colonne 16 comporte une première branche électrique 20, à laquelle la première électrode principale 12A de chaque interrupteur 12 de cette colonne 16 est reliée électriquement. Les premières branches 20 sont reliées électriquement entre elles à un premier nœud électrique 22.

Chaque colonne 16 comporte également une seconde branche électrique 24, à laquelle la seconde électrode principale 12B de chaque interrupteur 12 de cette colonne 16 est reliée électriquement. Les secondes branches 24 sont reliées électriquement entre elles à un second nœud électrique 26.

Par ailleurs, l'électrode de commande de chaque interrupteur 12 de chaque ligne 18 est reliée électriquement à une branche 28 de commande de cette ligne 18.

Chaque branche de commande 28 comporte par exemple un élément de commande 30, relié électriquement à l'électrode de commande de chaque interrupteur 12 de la ligne 18 correspondante au moyen d'une liaison de commande 32. L'élément de commande 30 est également reliée électriquement à chaque seconde électrode principale 12B de chaque interrupteur 12 de la ligne 18 au moyen d'une liaison de retour 38, afin de référencer les électrodes de commande 12C à ces secondes électrodes principale 12B.

Par ailleurs, chaque élément de commande 30 est relié à un dispositif 36 respectif d'alimentation électrique au moyen d'une liaison d'alimentation 34.

On notera que les branches de commande 28, notamment les éléments de commande 30 et les dispositifs d'alimentation 36, sont isolés galvaniquement les uns par rapport aux autres, afin d'éviter les interférences entre ces branches de commande 28.

De préférence, chaque branche de commande 28 est activée par un dispositif commun d'activation 40, formant un dispositif de commande générale du dispositif de commutation 10. Ainsi, chaque branche de commande 28 peut être activée simultanément, afin de commander la commutation de tous les interrupteurs 12 de la ligne 18 correspondante.

On notera que la commande des commutations des interrupteurs 12 par ligne, plutôt que dans leur ensemble, permet de limiter les décalages de commutation.

En effet, les impédances parasites associées à un interrupteur 12 respectif dépendent notamment des longueurs des moyens de connexion électrique de cet interrupteur 12 avec les premier 22 et second 26 noeuds électriques, c'est-à-dire de l'éloignement de cet interrupteur 12 aux premier 22 et second 26 nœuds électriques. En d'autres termes, un premier interrupteur proche du premier nœud électrique 22 sera associé à une impédance parasite du côté de ce premier nœud électrique 22 (côté drain) plus faible qu'un deuxième interrupteur de la même colonne, davantage éloigné de ce premier nœud électrique 22. Par ailleurs, le premier interrupteur sera davantage éloigné du second nœud électrique 26 que le deuxième interrupteur, si bien qu'il sera associé à une impédance parasite du côté du second nœud 26 (côté source) plus important que ce deuxième interrupteur.

En revanche, tous les interrupteurs 12 d'une même ligne 18 présentent le même éloignement aux nœuds électrique 22, 26 les uns par rapport aux autres, si bien que les impédances parasites associées à ces interrupteurs 12 sont sensiblement identiques. Ces interrupteurs d'une même ligne 18 peuvent donc être commutés sensiblement simultanément, en étant commandés par une même branche de commande 28.

En outre, les branches de commande 28 étant indépendantes les unes des autres, elles permettent de commuter les lignes 18 d'interrupteurs de manière indépendante, sans interférences pouvant causer des décalages de commutation.

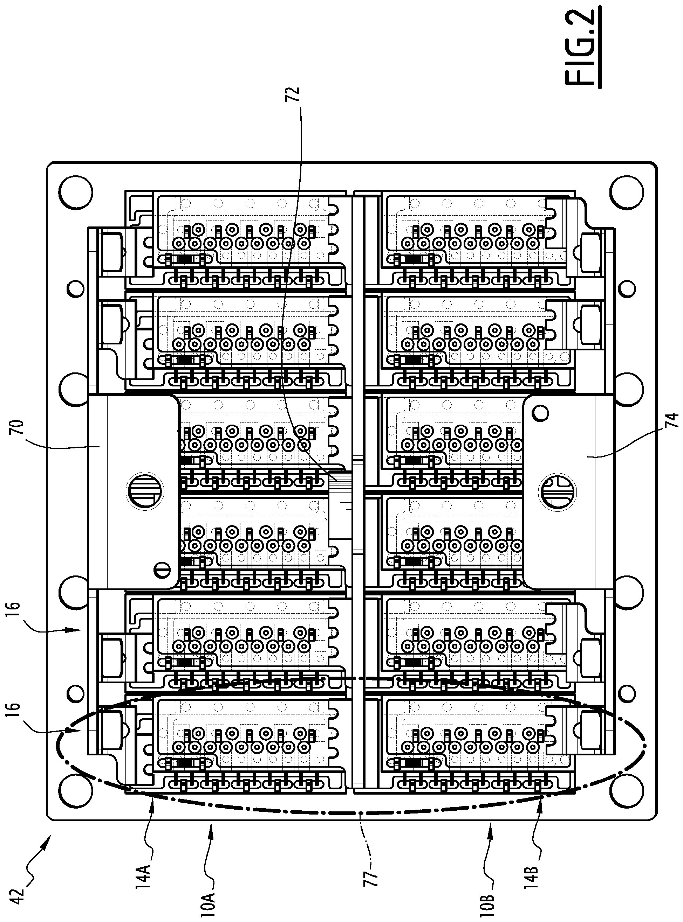

On a représenté sur les figures 2 à 6 un exemple de réalisation du dispositif de commutation de la figure 1.

En particulier, on a représenté sur la figure 2 un bras d'onduleur 42, comportant deux dispositifs de commutation, dits premier dispositif de commutation 10A et second dispositif de commutation 10B, dont les matrices respectives 14A, 14B sont similaires à celle 14 décrite en référence à la figure 1.

Un tel bras d'onduleur 42 est par exemple destiné à équiper un véhicule ferroviaire, afin de convertir un courant continu fourni par une caténaire en un courant alternatif pour alimenter un moteur du train en électricité.

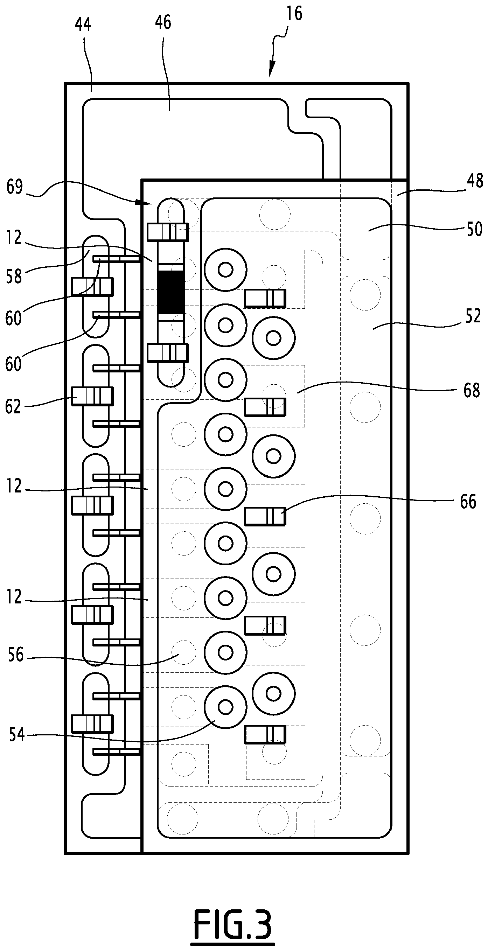

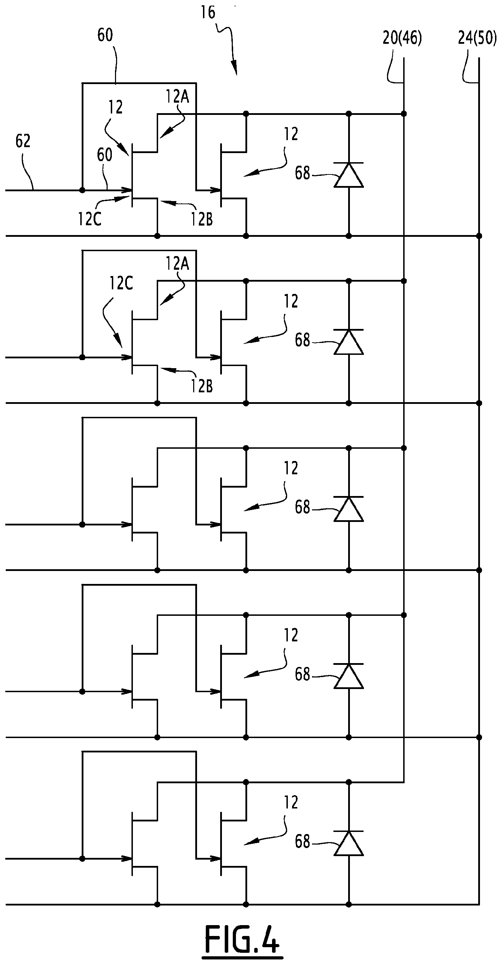

Chaque dispositif de commutation 10A, 10B comporte six colonnes 16 sensiblement identiques, dont l'une est représentée plus en détail sur la figure 3. Par soucis de clarté, un schéma électrique de cette colonne 16 est représenté sur la figure 4.

Chaque colonne 16 comporte un premier substrat isolant 44, par exemple en céramique, comportant une première piste conductrice 46, par exemple une piste de cuivre ou d'aluminium, formant la première branche électrique 20 de la colonne 16.

Chaque interrupteur 12 de cette colonne 16 est relié à la première piste 46, de sorte que la première électrode principale 12A de chacun de ces interrupteurs 12 est connectée à la piste conductrice 46. Par exemple, chaque interrupteur 12 de cette colonne 16 est brasé sur cette piste 46, mais il peut en variante être relié à cette piste 46 par tout autre moyen.

Chaque colonne 16 comporte également un second substrat isolant 48, par exemple en céramique, agencé sensiblement parallèlement au premier substrat 44, et présentant une face inférieure portant une deuxième piste conductrice 50 formant la seconde branche électrique 24 de la colonne 16, et une face supérieure, opposée à la face inférieure, portant une troisième piste 52 conductrice. La deuxième piste 50 et la troisième piste 52 sont reliées électriquement au moyen d'éléments de connexion 54, également appelés « via », traversant le second substrat 48.

La seconde électrode principale 12B de chaque interrupteur 12 est reliée électriquement à la deuxième piste 50, par exemple au moyen d'une bille conductrice 56 (appelée « bump » en anglais). En variante, la seconde électrode principale de chaque interrupteur 12 pourrait être reliée à la deuxième piste 50 par des moyens de connexion filaires. Toutefois, l'agencement en parallèle des substrats 44, 48, notamment de leurs pistes 46, 50, 52, permet, en combinaison avec de telles billes conductrices 56, de réduire l'inductance de boucle.

Par ailleurs, le premier substrat 44 comporte également au moins une piste de commande 58, par exemple cinq pistes de commande 58, chacune reliée à l'électrode de commande 12C d'au moins un interrupteur 12 au moyen d'un câble 60.

Par exemple, conformément au mode de réalisation décrit en référence aux figures 2 à 6, chaque piste de commande 58 est reliée à l'électrode de commande de deux interrupteurs 12. En d'autres termes, deux lignes 18 consécutives sont commandées par une même branche de commande 28. Un tel agencement est envisageable du fait que les impédances parasites associées aux interrupteurs 12 de deux lignes 18 consécutives diffèrent relativement peu, si bien que le décalage de commutation entre ces interrupteurs 12 est suffisamment faible pour ne pas altérer le fonctionnement du bras d'onduleur 42.

En variante, chaque ligne 18 d'interrupteurs 12 pourrait être reliée à une branche de commande 28 distincte, comme cela est représenté sur la figure 1. Toutefois, il est plus encombrant de fournir une branche de commande respective pour chaque ligne 18 plutôt qu'une branche de commande commune à deux lignes 18, si bien qu'on préférera généralement fournir une branche de commande commune à deux lignes 18 successives.

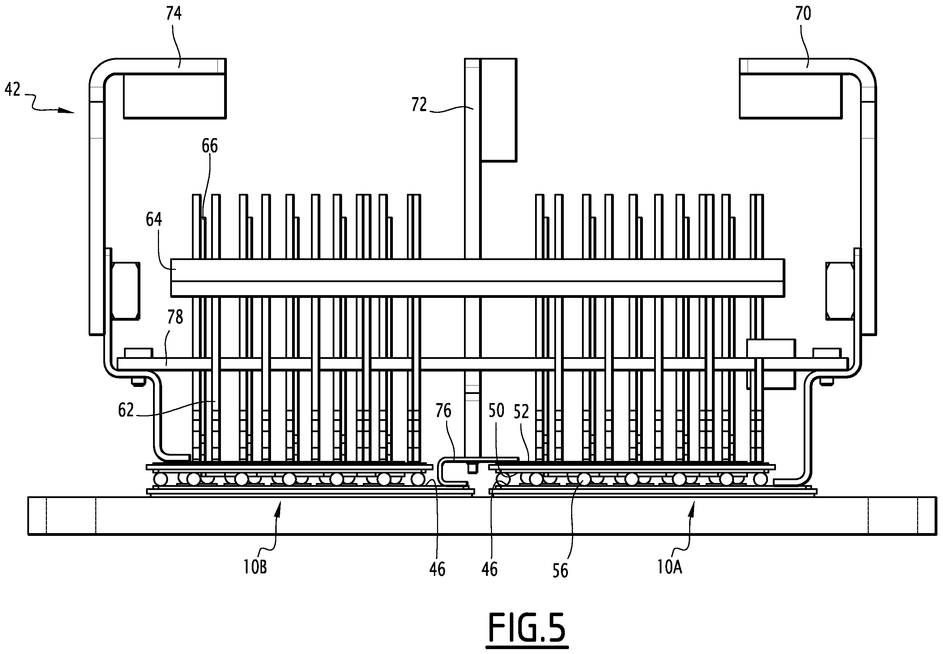

Chaque branche de commande 28 comporte une broche de commande 62, formant, avec le câble 60, la liaison de commande 32. Cette broche de commande 62 est reliée à la piste de commande 58 en s'étendant perpendiculairement au premier substrat 44, depuis cette piste de commande 58 jusqu'à une carte de commande 64 visible sur la figure 5.

Chaque branche de commande 28 comporte également une broche de retour 66, formant la liaison de retour 38, reliée électriquement à la troisième piste électrique 52, donc également à la seconde piste électrique 50, et s'étendant perpendiculairement au second substrat 48 jusqu'à la carte de commande 64.

On notera que la carte de commande 64 est agencée juste au dessus des interrupteurs 12, et les broches de commande 62 et de retour 66 sont agencés proches l'un de l'autre. Ainsi, on minimise l'inductance parasite de la branche de commande 28, ce qui est nécessaire pour permettre une commutation très rapide des interrupteurs 12.

La carte de commande 64 comporte les moyens d'alimentation 36 et les éléments de commande 30 de chaque branche de commande 28, ainsi que le dispositif de commande générale 40. On rappelle que les moyens d'alimentation 36, respectivement les éléments de commande 30, sont isolés galvaniquement les uns par rapport aux autres, afin de ne pas provoquer d'interférences entre eux.

En variante, les éléments de commande 30 pourraient être, au moins en partie, agencés sur le substrat 44, afin d'être agencés au plus près des interrupteurs 12. De cette manière, on diminuerait encore les impédances parasites de la boucle de commande 28.

Avantageusement, chaque colonne 16 comporte également au moins une diode 68, par exemple cinq diodes 68, comprenant chacune une anode reliée à la première branche électrique 46 et une cathode reliée à la seconde branche électrique 50. De telles diodes 68, dites antiparallèles, permettent de manière classique d'éviter les discontinuités de courrant aux bornes des interrupteurs 12.

De manière optionnelle, chaque colonne 16 comporte une thermistance 69, agencée sur la face supérieure du second substrat 48. Une telle thermistance 69 est destinée à collecter des informations concernant la température de la colonne 16, à des fins de surveillance du dispositif.

Comme cela est représenté sur la figure 2, les colonnes 16 du premier dispositif de commutation 10A sont connectées en parallèle, au moyen d'une première borne de connexion commune 70, formant le premier nœud électrique 22, à laquelle est connectée la première piste 46 de chaque colonne 16, et d'une deuxième borne de connexion commune 72, formant le second nœud électrique 26, à laquelle est connectée la troisième piste 52 de chaque colonne.

De manière similaire, les colonnes 16 du second dispositif de commutation 10B sont connectées en parallèle, au moyen de la deuxième borne de connexion commune 72, à laquelle est connectée la première piste 46 de chaque colonne 16, et d'une troisième borne de connexion commune 74, à laquelle est connectée la troisième piste 52 de chaque colonne 16.

On notera que le bras d'onduleur 42 comporte des ponts conducteurs 76, notamment visibles sur la figure 5, reliant chacun électriquement la troisième piste 52 d'une colonne 16 du premier dispositif 10A à la première piste 46 d'une colonne 16 du second dispositif 10B. Ainsi, les colonnes 16 des premier 10A et second 10B dispositifs de commutation qui sont reliées par un pont conducteur 76 forment ensemble une portion élémentaire 77 de bras d'onduleur.

On notera que chaque pont conducteur 76 est également relié à la deuxième borne de connexion 72.

Les première 70, deuxième 72 et troisième 74 bornes forment respectivement, une borne positive, une borne de phase et une borne négative d'onduleur.

Conformément à une variante de réalisation non représentée, les bornes positive 70 et négative 74 sont agencées proches l'une de l'autre, d'un même côté du bras d'onduleur 42, afin de réduire l'inductance parasite de boucle, par un effet dit « busbar » connu en soi.

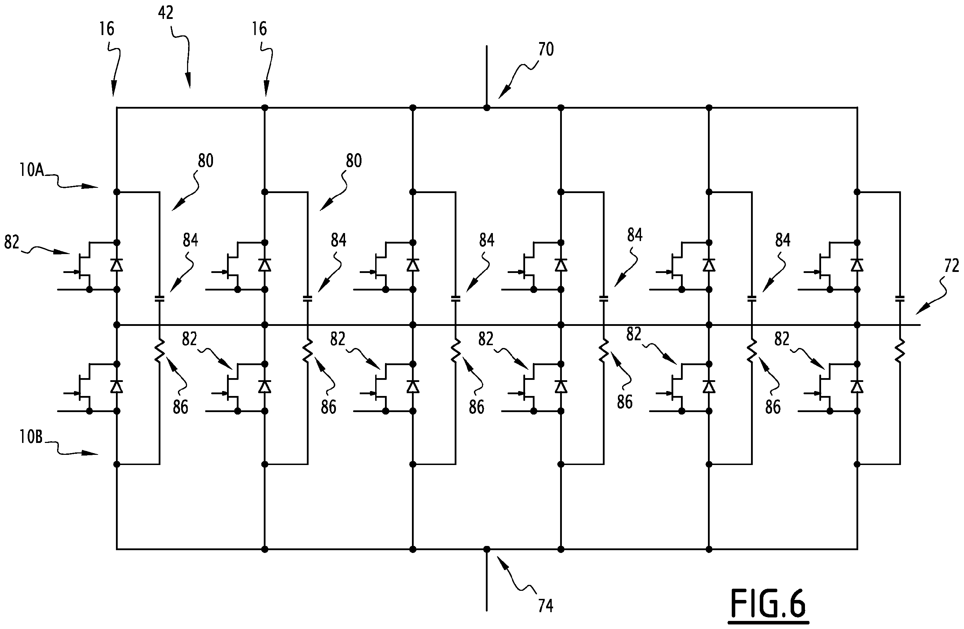

De manière avantageuse, le bras d'onduleur 42 comporte une carte de découplage 78, visible sur la figure 5. La carte de découplage comporte six circuits de découplage 80 indépendants, chaque circuit de découplage 80 étant associé à une portion élémentaire 77 respective. Les circuits de découplage 80 sont représentés de manière schématique sur la figure 6.

Sur cette figure 6, on a représenté, par soucis de lisibilité, l'ensemble des interrupteurs 12 de chaque colonne 16 de chaque dispositif de commutation 10A, 10B par un interrupteur équivalent 82.

Chaque circuit de découplage 80 est agencé en parallèle d'une portion élémentaire 77 de bras d'onduleur, afin de limiter les interférences entre ces portions élémentaires 77. A cet effet, chaque circuit de découplage 80 comporte un ensemble 84 de condensateurs connectés entre eux en parallèles (représenté par un condensateur équivalent sur la figure 6), connecté en série avec un ensemble de résistances 86 connectées entre eux en parallèles (représenté par une résistance équivalente sur la figure 6).

On notera que l'invention n'est pas limitée au mode de réalisation précédemment décrit, mais pourrait présenter diverses variantes sans sortir du cadre des revendications.

En particulier, le dispositif de commutation pourrait équiper tout type de structure de commutation, par exemple un bras de hacheur ou un Pont Monophasé à Commutation Forcée (PMCF), et/ou d'équiper tout type de système de traction électrique, par exemple pour une application ferroviaire, automobile, ou aéronautique, ou tout type de système de conversion et de production d'énergie, par exemple pour une application nucléaire, éolienne ou hydroélectrique.

## Revendications

1. Dispositif de commutation électrique (10), comportant une pluralité d'interrupteurs électroniques commandables (12), comprenant chacun une première électrode principale (12A), une seconde électrode principale (12B) et une électrode de commande (12C), dans lequel :
- les interrupteurs (12) sont agencés de façon à former une matrice (14) comportant au moins deux colonnes (16) comprenant chacune au moins deux interrupteurs (12), et au moins deux lignes (18) comportant chacune l'un des interrupteurs (12) de chaque colonne (16),
- la première électrode principale (12A) de chaque interrupteur (12) de chaque colonne (16) est reliée électriquement à une première branche électrique (20) de cette colonne (16), les premières branches (20) des colonnes (16) étant reliées électriquement entre elles à un premier nœud électrique (22),
- la seconde électrode principale (12B) de chaque interrupteur (12) de chaque colonne (16) est reliée électriquement à une seconde branche électrique (24) de cette colonne (16), les secondes branches (24) des colonnes (16) étant reliées électriquement entre elles à un second nœud électrique (26),
- le dispositif (10) comporte au moins deux branches de commande (28) distinctes, l'électrode de commande (12C) de chaque interrupteur (12) de chaque ligne (18) étant reliée électriquement à une même branche (28) de commande de cette ligne (18),
- chaque branche de commande (28) comporte un élément de commande (30), relié électriquement à l'électrode de commande (12C) de chaque interrupteur (12) de la ligne (18) correspondante, et relié à un dispositif (36) d'alimentation électrique
- chaque branche de commande (28) comporte un dispositif d'alimentation électrique (36) respectif
**caractérisé en ce que** :
- les dispositifs d'alimentation électrique (36) sont isolés galvaniquement les uns par rapport aux autres
- chaque colonne (16) comporte un premier substrat (44) comportant une première piste conductrice (46) formant la première branche électrique (20) de cette colonne (16), et un second substrat (48), agencé sensiblement parallèlement au premier substrat (44), comportant une deuxième piste conductrice (50) formant la seconde branche électrique (24) de la colonne (16).

2. Dispositif de commutation (10) selon la revendication 1, dans lequel chaque branche de commande (28) est activée au moyen d'un dispositif d'activation (40) commun.

3. Dispositif de commutation (10) selon l'une quelconque des revendications précédentes, dans lequel chaque branche de commande (28) est reliée aux électrodes de commande (12C) des interrupteurs (12) d'au moins deux lignes (18) adjacentes.

4. Dispositif de commutation (10) selon l'une quelconque des revendications précédentes, dans lequel chaque colonne (16) comporte au moins une diode (68) comprenant une anode reliée à la première branche électrique (20), et une cathode reliée à la seconde branche électrique (24).

5. Dispositif de commutation (10) selon l'une quelconque des revendications précédentes, dans lequel chaque interrupteur (12) est un transistor.

6. Dispositif de commutation (10) selon l'une quelconque des revendications précédentes, dans lequel la seconde électrode principale (12B) de chaque interrupteur (12) est reliée à la deuxième piste (50) au moyen d'une bille conductrice (56).

7. Dispositif de commutation (10) selon l'une quelconque des revendications précédentes, dans lequel le second substrat (48) présente une face inférieure, portant la deuxième piste (50), et une face supérieure opposée à la face inférieure, portant une troisième piste conductrice (52), reliée électriquement à la deuxième piste (50) au moyen d'éléments de connexion (54) traversant le second substrat (48).

8. Dispositif de commutation (10) selon l'une quelconque des revendications précédentes, dans lequel :
- le premier substrat (44) comporte au moins une piste de commande (58), reliée électriquement à l'électrode de commande (12C) d'au moins un interrupteur (12),
- le dispositif (10) comporte une broche de commande (62) reliée à cette piste de commande (58), s'étendant perpendiculairement au premier substrat (44) depuis cette piste de commande (58) jusqu'à une carte de commande (64) comprenant au moins une branche de commande (28) d'une ligne (18).

9. Dispositif de commutation (10) selon la revendication 8, comportant au moins une broche de retour (66), reliée électriquement à la deuxième piste électrique (50), s'étendant perpendiculairement au second substrat (48) jusqu'à la carte de commande (64).

10. Dispositif de commutation (10) selon l'une quelconque des revendications précédentes, dans lequel au moins un élément de commande (30) est agencé, au moins en partie, sur le premier substrat (44).

11. Dispositif de commutation (10) selon l'une quelconque des revendications précédentes, comportant une carte de découplage (78), comprenant au moins deux circuits de découplage (80), chaque circuit de découplage (80) étant agencé en parallèle d'une colonne (16), afin de limiter les interférences entre ces colonnes (16).

12. Bras d'onduleur (42), comportant :
- un premier (10A) et un second (10B) dispositif de commutation identiques selon l'une quelconque des revendications précédentes,
- une première borne (70), dite borne positive, connectée à la première branche (20) de chaque colonne (16) du premier dispositif de commutation (10A),
- au moins un pont conducteur (76), reliant électriquement la seconde branche (24) d'une colonne (16) du premier dispositif de commutation (10A) avec la première branche (20) d'une colonne (16) du second dispositif de commutation (10B),
- une deuxième borne (72), dite borne de phase, relié électriquement au pont conducteur (76), et
- une troisième borne (74), dite borne négative, connectée à la seconde branche (24) de chaque colonne (16) du second dispositif de commutation (10B).

13. Véhicule ferroviaire à alimentation électrique, comportant au moins un moteur électrique, **caractérisé en ce qu'**il comporte au moins un onduleur, comprenant trois bras d'onduleur (42) selon la revendication 12, destiné à alimenter le moteur en électricité.

14. Système de traction électrique, notamment pour une application ferroviaire, automobile, ou aéronautique, **caractérisé en ce qu'**il comporte un dispositif de commutation (10) selon l'une quelconque des revendications 1 à 11.

15. Système de conversion ou de production d'énergie, notamment pour une application nucléaire, éolienne ou hydroélectrique, **caractérisé en ce qu'**il comporte un dispositif de commutation (10) selon l'une quelconque des revendications 1 à 11.

## Patentansprüche

1. Elektrische Schaltvorrichtung (10), die eine Mehrzahl von steuerbaren elektronischen Schaltern (12) aufweist, die jeweils eine erste Hauptelektrode (12A), eine zweite Hauptelektrode (12B) und eine Steuerelektrode (12C) umfassen, bei der:
- die Schalter (12) derart angeordnet sind, dass sie eine Matrix (14) bilden, die mindestens zwei Spalten (16), von denen jede mindestens zwei Schalter (12) umfasst, und mindestens zwei Zeilen (18) aufweist, von denen jede einen der Schalter (12) jeder Spalte (16) aufweist,
- die erste Hauptelektrode (12A) jedes Schalters (12) jeder Spalte (16) elektrisch mit einem ersten elektrischen Strang (20) dieser Spalte (16) verbunden ist, wobei die ersten Stränge (20) der Spalten (16) elektrisch untereinander an einen ersten elektrischen Knoten (22) angeschlossen sind,
- die zweite Hauptelektrode (12B) jedes Schalters (12) jeder Spalte (16) elektrisch mit einem zweiten elektrischen Strang (24) dieser Spalte (16) verbunden ist, wobei die zweiten Stränge (24) der Spalten (16) elektrisch untereinander an einen zweiten elektrischen Knoten (26) angeschlossen sind,
- die Vorrichtung (10) mindestens zwei unterschiedliche Steuerstränge (28) aufweist, wobei jede Steuerelektrode (12C) jedes Schalters (12) jeder Zeile (18) elektrisch an einen selben Steuerstrang (28) dieser Zeile (18) angeschlossen ist,
- jeder Steuerstrang (28) ein Steuerelement (30) aufweist, das elektrisch mit der Steuerelektrode (12C) jedes Schalters (12) der entsprechenden Zeile (18) verbunden ist und an eine elektrische Versorgungsvorrichtung (36) angeschlossen ist,
- jeder Steuerstrang (28) eine jeweilige elektrische Versorgungsvorrichtung aufweist,
**dadurch gekennzeichnet, dass**:
- die elektrischen Versorgungsvorrichtungen (36) untereinander galvanisch getrennt sind,
- jede Spalte (16) ein erstes Substrat (44) aufweist, das eine erste Leiterbahn (46), die den ersten elektrischen Strang (20) dieser Spalte (16) bildet, und ein zweites Substrat (48) aufweist, das im Wesentlichen parallel zum ersten Substrat (44) angeordnet ist und eine zweite Leiterbahn (50) aufweist, die den zweiten elektrischen Strang (24) der Spalte (16) bildet.

2. Schaltvorrichtung (10) nach Anspruch 1, bei der jeder Steuerstrang (28) mittels einer gemeinsamen Aktivierungsvorrichtung (40) aktiviert wird.

3. Schaltvorrichtung (10) nach einem beliebigen der vorhergehenden Ansprüche, bei der jeder Steuerstrang (28) an die Steuerelektroden (12C) der Schalter (12) von mindestens zwei benachbarten Zeilen (18) angeschlossen ist.

4. Schaltvorrichtung (10) nach einem beliebigen der vorhergehenden Ansprüche, bei der jede Spalte (16) mindestens eine Diode (68) aufweist, die eine an den ersten elektrischen Strang (20) angeschlossene Anode und eine an den zweiten elektrischen Strang (24) angeschlossene Kathode umfasst.

5. Schaltvorrichtung (10) nach einem beliebigen der vorhergehenden Ansprüche, bei der jeder Schalter (12) ein Transistor ist.

6. Schaltvorrichtung (10) nach einem beliebigen der vorhergehenden Ansprüche, bei der die zweite Hauptelektrode (12B) jedes Schalters (12) mit der zweiten Leiterbahn (50) mittels einer leitenden Kugel (56) verbunden ist.

7. Schaltvorrichtung (10) nach einem beliebigen der vorhergehenden Ansprüche, bei der das zweite Substrat (48) eine die zweite Leiterbahn (50) tragende Unterseite und eine Oberseite, entgegengesetzt zur Unterseite, aufweist, die eine dritte Leiterbahn (52) trägt, die elektrisch mit der zweiten Leiterbahn (50) mittels Verbindungselementen (54) verbunden ist, die das zweite Substrat (48) durchqueren.

8. Schaltvorrichtung (10) nach einem beliebigen der vorhergehenden Ansprüche, bei der:
- das erste Substrat (44) mindestens eine Steuerbahn (58) aufweist, die elektrisch mit der Steuerelektrode (12C) mindestens eines Schalters (12) verbunden ist,
- die Vorrichtung (10) einen Steuerkontaktstift(62) aufweist, der an diese Steuerbahn (58) angeschlossen ist und sich senkrecht zum ersten Substrat (44) von der Steuerbahn (58) bis zu einer Steuerkarte (64) erstreckt, die mindestens einen Steuerstrang (28) einer Zeile (18) umfasst.

9. Schaltvorrichtung (10) nach Anspruch 8, die mindestens einen Rückführkontaktstift (66) aufweist, der elektrisch mit der zweiten Leiterbahn (50) verbunden ist, und sich senkrecht zum zweiten Substrat (48) bis zu der Steuerkarte (64) erstreckt.

10. Schaltvorrichtung (10) nach einem beliebigen der vorhergehenden Ansprüche, bei der mindestens ein Steuerelement (30) zumindest teilweise auf dem ersten Substrat (44) angeordnet ist.

11. Schaltvorrichtung (10) nach einem beliebigen der vorhergehenden Ansprüche, die eine Entkopplungskarte (78) aufweist, die mindestens zwei Entkopplungsschaltkreise (80) umfasst, wobei jeder Entkopplungsschaltkreis (80) parallel zu einer Spalte (16) angeordnet ist, um Interferenzen zwischen diesen Spalten (16) zu begrenzen.

12. Wechselrichterzweig (42), umfassend:
- eine erste (10A) und eine zweite (10B) identische Schaltvorrichtung nach einem beliebigen der vorhergehenden Ansprüche,
- eine erste Klemme (70), genannt positive Klemme, die an den ersten Strang (20) jeder Spalte (16) der ersten Schaltvorrichtung (10A) angeschlossen ist,
- mindestens eine Leitungsbrücke (76), die elektrisch den zweiten Strang (24) einer Spalte (16) der ersten Schaltvorrichtung (10A) mit dem ersten Strang (20) einer Spalte (16) der zweiten Schaltvorrichtung (10B) verbindet,
- eine zweite Klemme (72), genannt Phasenklemme, die elektrisch mit der Leitungsbrücke (76) verbunden ist und
- eine dritte Klemme (74), genannt negative Klemme, die mit dem zweiten Strang (24) jeder Spalte (16) der zweiten Schaltvorrichtung (10B) verbunden ist.

13. Schienenfahrzeug mit elektrischer Versorgung, das mindestens einen elektrischen Motor aufweist, **dadurch gekennzeichnet, dass** es mindestens einen Wechselrichter aufweist, der drei Wechselrichterzweige (42) nach Anspruch 12 umfasst, die vorgesehen sind, den Motor elektrisch zu versorgen.

14. Elektrisches Fahrantriebssystem, insbesondere für eine Eisenbahn-, Automobil- oder Luftfahrtanwendung, **dadurch gekennzeichnet dass** es eine Schaltvorrichtung (10) nach einem beliebigen der Ansprüche 1 bis 11 aufweist.

15. System zur Energieumwandlung oder -erzeugung, insbesondere für eine Nuklear-, Windkraft- oder Wasserkraftanwendung, **dadurch gekennzeichnet, dass** es eine Schaltvorrichtung (10) nach einem beliebigen der Ansprüche 1 bis 11 aufweist.

## Claims

1. An electric switchgear (10), of the type including a plurality of controllable electronic switches (12), each comprising a first primary electrode (12A), a second primary electrode (12B) and a control electrode (12C), wherein:
- the switches (12) are arranged so as to form a matrix (14) having at least two columns (16) each comprising at least two switches (12), and at least two lines (18) each including one of the switches (12) from each column (16),
- the first primary electrode (12A) of each switch (12) of each column (16) is electrically connected to a first electric branch (20) of that column (16), the first branches (20) of the columns (16) being electrically connected to one another at a first electric node (22),
- the second primary electrode (12B) of each switch (12) of each column (16) is electrically connected to a second electric branch (24) of said column (16), the second branches (24) of the columns (16) being electrically connected to one another at a second electric node (26),
- the device (10) includes at least two distinct control branches (28), the control electrode (12C) of each switch (12) of each line (18) being electrically connected to a same control branch (28) of that line (18),
- each control branch (28) includes a control element (30), electrically connected to the control electrode (12C) of each switch (12) of the corresponding line (18), and connected to an electric power supply device (36),
- each control branch (28) includes the respective electric power supply device (36),
**characterized in that**:
- the power supply devices (36) are galvanically isolated from one another,
- each column (16) includes a first substrate (44) having a first conductive track (46) forming the first electric branch (20) of that column (16), and a second substrate (48), arranged substantially parallel to the first substrate (44), including a second conductive track (50) forming the second electric branch (24) of the column (16).

2. The switchgear (10) according to claim 1, wherein each control branch (28) is activated using a shared activation device (40).

3. The switchgear (10) according to any one of the preceding claims, wherein each control branch (28) is connected to the control electrodes (12C) of the switches (12) of at least two adjacent rows (18).

4. The switchgear (10) according to any one of the preceding claims, wherein each column (16) includes at least one diode (68) comprising an anode connected to the first electric branch (20), and cathode connected to the second electric branch (24).

5. The switchgear (10) according to any one of the preceding claims, wherein each switch (12) is a transistor.

6. The switchgear (10) according to any one of the preceding claims, wherein the second primary electrode (12B) of each switch (12) is connected to the second track (50) via a bump (56).

7. The switchgear (10) according to any one of the preceding claims, wherein the second substrate (48) has a lower surface, supporting the second track (50), and an upper surface opposite the lower surface, supporting a third conductive track (52), electrically connected to the second track (50) using connection elements (54) passing through the second substrate (48).

8. The switchgear (10) according to any one of the preceding claims, wherein:
- the first substrate (44) includes at least one control track (58), electrically connected to the control electrode (12C) of at least one switch (12),
- the device (10) includes a control pin (62) connected to said control track (58), extending perpendicular to the first substrate (44) from said control track (58) to a control board (64) comprising at least one control branch (28) of a line (18).

9. The switchgear (10) according to claim 8, including at least one return pin (66), electrically connected to the second electric track (50), extending perpendicular to the second substrate (48) as far as the control board (64).

10. The switchgear (10) according to any one of the preceding claims, combined with any one of claims 9 to 13, wherein at least one control element (30) is arranged, at least partially, on the first substrate (44).

11. The switchgear (10) according to any one of the preceding claims, wherein including a decoupling board (78), comprising at least two decoupling circuits (80), each decoupling circuit (80) being arranged parallel to a column (16), so as to limit interference between said columns (16).

12. An inverter arm (42), including:
- first (10A) and second (10B) identical switchgears according to any one of the preceding claims,
- a first terminal (70), called positive terminal, connected to the first branch (20) of each column (16) of the first switchgear (10A),
- at least one conductive bridge (76), electrically connecting the second branch (24) of a column (16) of the first switchgear (10A) with the first branch (20) of the column (16) of the second switchgear (10B),
- a second terminal (72), called phase terminal, electrically connected to the conductive bridge (76), and
- a third terminal (74), called negative terminal, connected to the second branch (24) of each column (16) of the second switchgear (10B).

13. An electrically powered railway vehicle, having at least one electric engine, **characterized in that** it includes at least one inverter, comprising three inverter arms (42) according to claim 12, intended to supply the engine with electricity.

14. An electric traction system, in particular for a railway, automobile, or aeronautic application, **characterized in that** it includes a switchgear (10) according to any one of claims 1 to 11.

15. A system for converting or producing energy, in particular for a nuclear, wind, or hydroelectric application, **characterized in that** it includes a switchgear (10) according to any one of claims 1 to 11.
